# EUROPÄISCHE PATENTANMELDUNG

(11) **EP 4 329 200 A1**
(43) Veröffentlichungstag der Anmeldung: **28.02.2024**
(21) Anmeldenummer: 23185743.4
(22) Anmeldetag: 17.07.2023
(51) Int. Cl.: H03K 17/96

(54) **HEIZGERÄT MIT EINEM GEHÄUSE**

(30) Priorität: 25.08.2022 DE 102022208775
(71) Anmelder: Robert Bosch GmbH, 70442 Stuttgart (DE)
(72) Erfinder: Wieland, Bernd, 73760 Ostfildern (DE); Baasner, Bernd, 73730 Esslingen (DE); Fischer, Ralf, 73730 Esslingen (DE); Mertens, Ramon, 7314 AR Apeldoorn (NL); Cantuerk, Yildirim, 73230 Kirchheim (DE); Veldwijk, Robert, 7384DK Wilp (NL)

(57) **Zusammenfassung**

Die Erfindung betrifft ein Heizgerät (10) mit einem Gehäuse (22) und mit in dem Gehäuse (22) angeordneten Komponenten (26), wobei mindestens eine Komponente (26) ein Steuermodul (36) umfasst, welches Anzeigeelemente (16) und/oder Bedienelemente (15) aufweist. Es wird vorgeschlagen, dass das Steuermodul (36) an mindestens zwei unterschiedlichen Stellen (38, 40) im oder am Gehäuse (22) anordenbar ist.

## Beschreibung

Die Erfindung betrifft ein Heizgerät mit einem Gehäuse und mit in dem Gehäuse angeordneten Komponenten. Mindestens eine der Komponenten umfasst ein Steuermodul, welches Anzeigeelemente und/oder Bedienelemente aufweist.

### Stand der Technik

Mit der DE 102016226306A1 ist ein Heizgerät mit einem Bediensystem bekannt geworden, wobei das Bediensystem eine Abdeckung aufweist, die dazu eingerichtet ist, ein Bedienfeld des Bediensystems abzudecken.

### Offenbarung der Erfindung

### Vorteile

Das erfindungsgemäße Heizgerät ist dadurch gekennzeichnet, dass das Steuermodul an mindestens zwei unterschiedlichen Stellen im oder am Gehäuse anordenbar ist. Dadurch wird erreicht, dass beispielsweise in einem Servicefall das Steuermodul an unterschiedlichen Positionen im Heizgerät oder auch außerhalb des Heizgeräts angeordnet werden kann. Auf diese Weise wird Platz geschaffen, die für die Wartung dann zur Verfügung steht. Unter anordenbar soll verstanden werden, dass das Steuermodul an einem solchen Ort bzw. an einer solchen Position abgelegt oder auch befestigt werden kann. Insbesondere soll an einer solchen Position die Funktion des Steuermoduls aufrechterhalten werden, d.h., dass das Steuermodul das Heizgerät auch weiter ganz oder teilweise betreiben kann.

In den Unteransprüchen sind vorteilhafte Weiterbildungen des erfindungsgemäßen Heizgeräts nach dem Hauptanspruch möglich. So kann die Anordnung einfach dadurch realisiert werden, dass mindestens zwei unterschiedliche Steckplätze vorgesehen sind. Ein solcher Steckplatz beinhaltet, dass das Steuermodul elektrisch mit dem Heizgerät bzw. dessen Komponenten verbunden werden kann. D.h., das Steuermodul wird direkt in einen solchen Steckplatz eingesteckt oder indirekt mit einem solchen Steckplatz über einen Adapter oder ein Kabel verbunden.

In einer vorteilhaften Ausgestaltung ist eine der Stellen, an denen das Steuermodul anordenbar ist, so vorgesehen, dass die Anzeigeelemente und/oder die Bedienelemente von außerhalb des Gehäuses des Heizgeräts gesehen und/oder bedient werden können. In einer solchen Position wird das Steuermodul bevorzugt während einem normalen Betrieb angeordnet sein.

In einer technisch einfachen Ausführung ist im Heizgerät eine bewegbare Komponente vorgesehen, die insbesondere zwischen mindestens zwei Positionen schwenkbar ist. Mit dieser Komponente ist es möglich, im Servicefall im Heizgerät gegebenenfalls verdeckte Bereiche freizugeben.

Die bewegbare Komponente kann bevorzugt zwei Steckplätze aufweisen. In einer besonders bevorzugten Art und Weise sind die Steckplätze an gegenüberliegenden, voneinander wegweisenden Seiten der bewegbaren Komponente angeordnet. Dadurch wird erreicht, dass das Steuermodul abhängig von der Positionierung der bewegbaren Komponente auf gegenüberliegenden Seiten platziert werden kann.

Im Heizgerät kann eine oder die bewegbare Komponente als eine bewegliche Serviceklappe im Gehäuse realisiert sein, die zwischen mindestens einer ersten Position und einer zweiten Position bewegbar ist. In der ersten Position befindet sich die bewegbare Komponente beziehungsweise die Serviceklappe während des Betriebs des Heizgeräts. In der zweiten Position befindet sich die bewegbare Komponente beziehungsweise die Serviceklappe in einer Position, in der Servicearbeiten vorgenommen werden können. In einer besonders bevorzugten Ausführungsweise ist die bewegbare Komponente bzw. die Serviceklappe in der zweiten Position nach vorne geklappt.

Es ist von Vorteil, wenn das Steuermodul auf einer ersten Seite der bewegbaren Komponente beziehungsweise der Serviceklappe in der ersten Position anbringbar oder angebracht ist und dass das Steuermodul auf einer zweiten Seite in der zweiten Position anbringbar oder angebracht ist.

Natürlich ist es im Rahmen der Erfindung denkbar, mehr als zwei Positionen vorzusehen, an denen das Steuermodul anbringbar ist. Damit kann dann einfach auf verschiedene Betriebs- oder Wartungsbedingungen reagiert werden.

Ist verhindert, dass die bewegbare Komponente beziehungsweise die Serviceklappe von der zweiten Position in die erste Position überführt werden kann, wenn das Steuermodul an der für den Servicefall vorgesehenen Seite angeordnet ist, ist gewährleistet, dass das Steuermodul im Anschluss an einen durchgeführten Service wieder an die Position gebracht wird, in der es für den Betrieb des Heizgeräts benötigt wird.

Eine vorteilhafte Weiterbildung ist gegeben, wenn das Steuermodul über einen Adapter und/oder ein Kabel elektrisch mit dem Heizgerät bzw. dessen Komponenten verbindbar ist. Auf diese Weise sind mehrere Möglichkeiten gegeben, an denen das Steuermodul platziert werden kann. Es ist sogar denkbar, dass das Steuermodul zum Beispiel für Reparaturzwecke gänzlich aus dem Gehäuse des Heizgeräts herausgenommen und außerhalb platziert wird, um genügend Raum für eine Reparatur bereitzustellen.

### Zeichnung

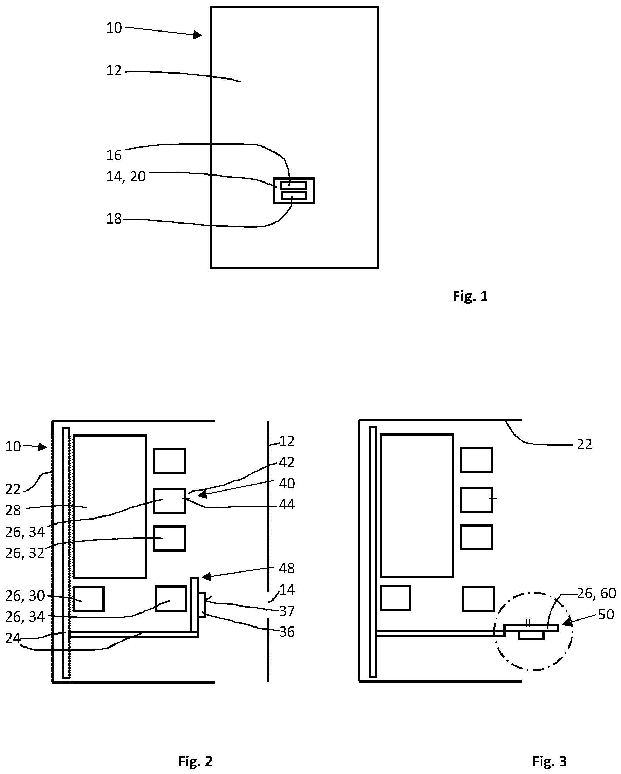

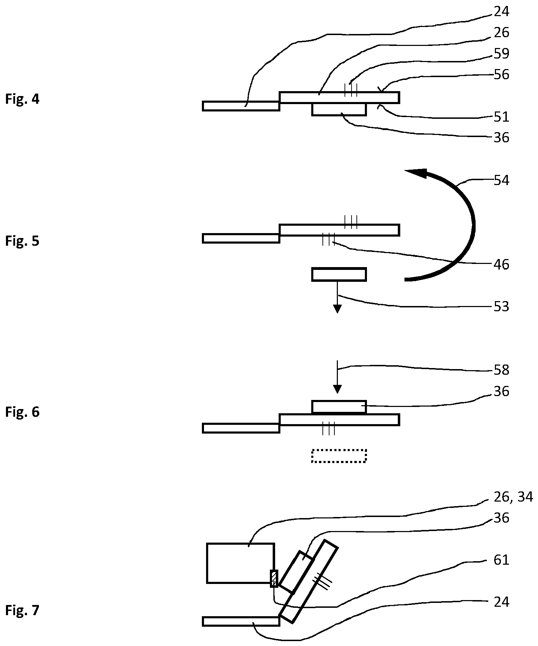

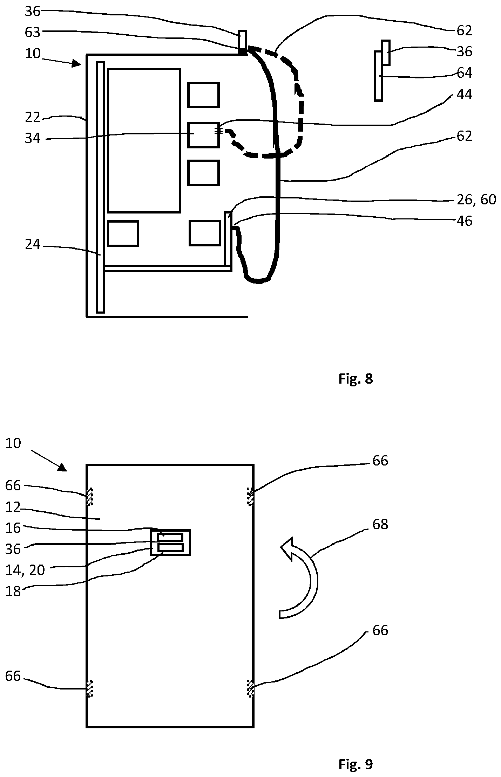

Es zeigen die Figur 1 ein Heizgerät von vorne, die Figuren 2 und 3 das Heizgerät nach Figur 1 von der Seite, schematisch in einem Schnitt, die Figuren 4 bis 7 eine bewegliche Komponente des Heizgeräts, die Figur 8 ein weiteres Ausführungsbeispiel entsprechend der Figuren 2 oder 3 und die Figur 9 ein weiters Ausführungsbeispiel entsprechend der Figur 1.

### Beschreibung

In den Figuren 1 bis 9 sind gleiche Bauteile der unterschiedlichen Ausführungsbeispiele mit gleichen Bezugszahlen versehen.

In Figur 1 ist ein Heizgerät 10 in einer Frontansicht mit Blick auf eine Frontplatte 12 gezeigt. In einem unteren, mittig angeordneten Bereich ist ein Fenster 14 vorgesehen, durch das Anzeigeelemente 16 und Bedienelemente 18 erkennbar sind. Je nach Konfiguration des Heizgeräts 10 können hier mehr oder weniger Anzeigeelemente 16 und/oder Bedienelemente 18 angeordnet sein. Im Ausführungsbeispiel ist das Fenster 14 eine Öffnung 20, durch die hindurch die Anzeigeelemente 16 und Bedienelemente 18 erkennbar bzw. bedienbar sind. Es ist auch möglich, das Fenster 14 mit einer transparenten Abdeckung zu versehen, durch die hindurch die Anzeigeelemente 16 erkennbar sind und die, je nach Ausführung, das Bedienen der Bedienelemente 18 erlaubt. Hierfür kann eine weiche, nachgiebige Abdeckung oder eine für Berührungen sensitive Abdeckung benutzt werden.

In der Figur 2 ist das Heizgerät 10 von der Seite im Schnitt dargestellt. Es handelt sich dabei um eine Darstellung, in der Komponenten 26 schematisch wiedergegeben sind. So ist ein Gehäuse 22 erkennbar, von dem die Frontplatte 12 abgenommen ist. Des Weiteren ist ein Gestell 24 angedeutet, das einzelne Komponenten 26 aufzunehmen vermag. Als Komponenten 26 sind hier unter anderem eine einen nicht dargestellten Brenner, eine Brennkammer und einen Wärmeübertrager aufnehmende, sogenannte Wärmezelle 28, eine oder mehreren Pumpen 30, ein oder mehrere Ventile 32 und eine oder mehrere, Niederspannung oder Hochspannung aufweisende Steuereinheiten 34 gezeigt. Weitere oder weniger Komponenten 26 können je nach Ausstattungsgrad des Heizgeräts 10 vorgesehen sein.

Im Heizgerät 10 ist als eine Komponente 26 ein Steuermodul 36 angeordnet. Dieses Steuermodul 36 weist im Ausführungsbeispiel die Anzeigeelemente 16 sowie die Bedienelemente 18 an einer Fronseite 37 auf. Es ist nun vorgesehen, dass das Steuermodul 36 an mindestens zwei unterschiedlichen Stellen 38 und 40 im Gehäuse 22 anordenbar ist. Die erste Stelle 38 ist im Ausführungsbeispiel an der Komponente 26 und die zweite Stelle 40 ist an einer weiteren Komponente 26, im Ausführungsbeispiel an einer Steuereinheit 34, vorgesehen.

Im ersten Ausführungsbeispiel ist das Steuermodul 36 steckbar ausgeführt. Darunter soll verstanden werden, dass das Steuermodul 36 mit einem Stecksystem ausgestattet ist. Im Ausführungsbeispiel weist das Steuermodul 36 nicht dargestellte, Steckerzungen aufnehmende Öffnungen auf. Die Steckerzungen 42 sind beispielsweise an der Steuereinheit 34 erkennbar. Natürlich ist es auch möglich, das Steuermodul 36 mit solchen Steckerzungen 42 auszustatten, die dann mit entsprechenden Öffnungen der Komponenten 26 korrespondieren können.

Wie bereits erwähnt, ist die Steuereinheit 34 mit Steckerzungen 42 ausgestattet und übernimmt somit die Funktion eines weiteren Steckplatzes 44 für das Steuermodul 36. Das heißt, das Steuermodul 36 kann von der Komponente 26 abgezogen und am weiteren Steckplatz 44 eingesteckt werden. Die erste Stelle 38 ist damit so ausgestaltet, dass die Anzeigeelemente 16 und die Bedienelemente 18 von außerhalb des Gehäuses 22 gesehen werden können. Wird für eine Reparatur oder eine Wartung die Frontplatte 12 abgenommen, kann das Steuermodul 36 vom Steckplatz 46 der ersten Stelle 38 abgezogen und auf den weiteren Steckplatz 44 der zweiten Stelle aufgesteckt werden. Dadurch ist erreicht, dass das Steuermodul 36 an einen Platz gebracht werden kann, der für die Reparatur oder die Wartung des Heizgeräts 10 geeigneter ist.

In der Figur 3 ist dargestellt, dass die Komponente 26, an der das Steuermodul 36 während des normalen Betriebs angeordnet ist, von einer ersten Position 48 in eine zweite Position 50 geschwenkt werden kann. Dadurch wird der Bereich unter der Wärmezelle 28 besser erreichbar. Es ist erkennbar, dass das Steuermodul 36 mit seinen Anzeigeelementen 16 und den Bedienelementen 18 nach unten weist. Das Bedienen des Heizgeräts 10 ist auf diese Weise eingeschränkt.

In den Figuren 4 bis 6 ist dargestellt, wie das auf einer ersten Seite 51 des Steuermoduls 36 vom ersten Steckplatz 46 abgezogen und auf einen weiteren Steckplatz, im Ausführungsbeispiel ein zweiter Steckplatz 52 an der bewegbaren Komponente 26, aufgesteckt werden kann. Die bewegbare Komponente 26 ist gemäß Figur 4 bereits in einer geschwenkten, zweiten Position 50 positioniert. Das Steuermodul 36 befindet sich somit unterhalb der bewegbaren Komponente 26, die Anzeigeelemente 16 und die Bedienelemente 18 sind nur unzureichend zugänglich.

In Figur 5 ist erkennbar, dass das Steuermodul 36 vom Steckplatz 46 entlang des Pfeils 53 abgezogen worden ist. Es wird dann entsprechend dem Pfeil 54 auf die dann oben gelegene Seite 56 so gebracht, dass die Anzeigeelemente 16 und Bedienungselemente 18 nach oben zeigen. Entlang des Pfeiles 58 wird das Steuermodul 36 dann auf einen Steckplatz 59 aufgesteckt. Das Steuermodul 36 nimmt damit analog zu seiner vorhergehenden Position Kontakt zu einer Steuereinheit für das Heizgerät 10 auf. Bei dieser Ausführung ist es von Vorteil, dass die beiden einander gegenüberliegenden Steckplätze 46, 59 über gemeinsame oder miteinander verbundenen Leiterbahnen ausgeführt sein können.

In einer besonderen Ausführung ist die bewegbare Komponente 26 als Serviceklappe 60 ausgeführt. Das heißt, dass die bewegbare Komponente 26 zum Beispiel als Ablagefläche für Werkzeuge oder Ersatzteile dienen kann. Im Servicefall wird die Serviceklappe 60 zwischen mindestens einer ersten Position 48 und einer zweiten Position 50 bewegt, wobei sich die Serviceklappe 60 in der ersten Position 48 während des Betriebs des Heizgeräts 10 befindet und wobei die Serviceklappe 60 in eine zweite Position 50 für Servicearbeiten bewegbar ist.

Das Steuermodul 32 kann dann auf der ersten Seite der Serviceklappe 60 in der ersten Position angebracht sein und nach dem Aufklappen der Serviceklappe 60 in eine zweite Position eingesteckt werden.

In der Figur 7 ist gezeigt, dass die bewegbare Komponente 26 bzw. die Serviceklappe 60 von der zweiten Position 50 nicht mehr in die erste Position 48 gebracht werden kann, wenn das Steuermodul 36 noch an der für den Servicefall vorgesehenen Seite angeordnet ist. Das Steuermodul 36 stößt mit seiner äußeren Begrenzung an einer der Komponenten 26 oder an einem Teil des Gestells 24 an, sodass die erste Position 48 nicht mehr eingenommen werden kann. Einem Servicetechniker fällt damit auf, dass das Steuermodul 36 noch nicht wieder zurückgesetzt wurde.

In einer weiteren Ausführungsform, dargestellt in der Figur 8, ist das Steuermodul 36 mit einem Kabel 62 elektrisch mit dem Heizgerät 10 bzw. dessen Komponenten 26 verbunden. Im Servicefall oder bei einer Reparatur kann das Steuermodul 36 von seiner Position während des Betriebs in fast jede andere Position gebracht werden. Es kann also sowohl innerhalb des Gehäuses 22 als auch außerhalb des Gehäuses 22 platziert werden. In einer besonders vorteilhaften Ausführungsform weist das Steuermodul 36 an seinen Außenseiten Magnete 63 auf, über die es am Gehäuse 22 lösbar befestigbar ist. In Figur 8 ist das Steuermodul oben auf dem Gehäuse 42 des Heizgeräts 10 platziert und über einen Magnet fixiert. In Figur 8 ist auch gestrichelt dargestellt, dass der Anschluss des Kabels 62 an einem anderen Steckplatz 44 eingesteckt sein kann.

Anstatt eines Kabels 62 kann auch ein Adapter 64 eingesetzt werden, wie er in Figur 8 alternativ dargestellt ist. An dem Adapter 64 wird dann das Steuermodul 36 eingesteckt. Auch darüber können eine bessere Lesbarkeit, Bedienbarkeit und mehr Platz für Reparaturarbeiten erzielt werden.

In der Figur 9 ist eine weitere Ausführung des Heizgeräts 10 dargestellt, die sich durch die multiple Anordenbarkeit des Steuermoduls 36 mit ergibt. Dabei ist das Steuermodul 36 entweder auf einem Steckplatz 44 an einer Steuereinheit 34 angeordnet, die höher im Heizgerät 10 liegt, oder an einer beliebigen Komponente 26 im Heizgerät 10. Im letzteren Fall wird das Steuermodul 36 über ein Kabel 62 mit einer Steuereinheit 34 verbunden. Der Platz im Heizgerät 10 ist so gewählt, dass der Abstand von der oberen Wand gleich dem ist, den das Steuermodul 36 haben würde, wenn es in der in Figur 1 dargestellten Position angeordnet wäre. In diesem Fall kann die Frontplatte 12 weiter benutzt werden. Die Frontplatte 12 wird dazu lediglich um 180° entsprechend dem Pfeil 68 gedreht. Zum Befestigen der Frontplatte 12 mit dem Gehäuse 22 sind Rastelemente 66 vorgesehen, die ebenfalls auf Umschlag passen und mit dem Gehäuse 22 in beiden möglichen Positionen verrasten können. Das Steuermodul 36 kann damit mit seinen Anzeigeelementen 16 und Bedienelementen 18 durch das Fenster 14 gesehen und bedient werden.

## Patentansprüche

1. Heizgerät (10) mit einem Gehäuse (22) und mit in dem Gehäuse (22) angeordneten Komponenten (26), wobei mindestens eine Komponente (26) ein Steuermodul (36) umfasst, welches Anzeigeelemente (16) und/oder Bedienelemente (15) aufweist, **dadurch gekennzeichnet, dass** das Steuermodul (36) an mindestens zwei unterschiedlichen Stellen (38, 40) im oder am Gehäuse (22) anordenbar ist.

2. Heizgerät (10) nach Anspruch 1, **dadurch gekennzeichnet, dass** mindestens zwei unterschiedliche Steckplätze (44, 46, 59) vorgesehen sind.

3. Heizgerät (10) nach einem der vorhergehenden Ansprüche, **dadurch gekennzeichnet, dass** eine der Stellen (38, 40) so vorgesehen ist, dass die Anzeigeelemente (16) und/oder die Bedienelemente (18) von außerhalb des Gehäuses (22) gesehen und/oder bedient werden können.

4. Heizgerät (10) nach einem der vorhergehenden Ansprüche, **dadurch gekennzeichnet, dass** innerhalb des Gehäuses (22) eine bewegbare, insbesondere zwischen mindestens zwei Positionen (48, 50) schwenkbare Komponente (26) angeordnet ist, die das Steuermodul (36) aufnimmt.

5. Heizgerät (10) nach Anspruch 4, **dadurch gekennzeichnet, dass** die bewegbare Komponente (26) mindestens zwei Steckplätze (44, 46, 59) aufweist.

6. Heizgerät (10) nach Anspruch 5, **dadurch gekennzeichnet, dass** die Steckplätze (44, 45, 59) an gegenüberliegenden, voneinander wegweisenden Seiten (51, 56) der bewegbaren Komponente (26) angeordnet sind.

7. Heizgerät (10) nach einem der vorhergehenden Ansprüche, **dadurch gekennzeichnet, dass** eine oder die bewegbare Komponente (26) als eine bewegbare Serviceklappe (60) im Gehäuse (22) realisiert ist, die zwischen mindestens einer ersten Position (48, 50) und einer zweiten Position bewegbar ist, wobei sich die Serviceklappe (60) in der ersten Position (48) während des Betriebs des Heizgeräts (10) befindet und wobei die Serviceklappe (60) in die zweite Position (50) für Servicearbeiten bewegbar ist.

8. Heizgerät (10) nach einem der vorhergehenden Ansprüche, **dadurch gekennzeichnet, dass** das Steuermodul (36) auf einer ersten Seite (51) der bewegbaren Komponente (26) beziehungsweise der Serviceklappe (60) in der ersten Position (48) anbringbar oder angebracht ist und dass das Steuermodul (36) auf einer zweiten Seite () in der zweiten Position (50) anbringbar oder angebracht ist.

9. Heizgerät (10) nach einem der vorhergehenden Ansprüche, **dadurch gekennzeichnet, dass** ein Überführen der bewegbaren Komponente (26) beziehungsweise der Serviceklappe (60) von der zweiten Position (50) in die erste Position (48) verhindert ist, wenn das Steuermodul (36) an der für den Servicefall vorgesehenen Seite (56) angeordnet ist.

10. Heizgerät (10) nach einem der vorhergehenden Ansprüche, **dadurch gekennzeichnet, dass** das Steuermodul (36) über einen Adapter (64) und/oder ein Kabel (62) elektrisch mit dem Heizgerät (10) bzw. dessen Komponenten (26) verbindbar ist.
